# EUROPEAN PATENT SPECIFICATION

(11) **EP 1 349 254 B1**
(45) Date of publication and mention of the grant of the patent: **28.03.2012**
(21) Application number: 02425196.9
(22) Date of filing: 29.03.2002
(51) Int. Cl.: H02J 1/10

(54) **Power rectifier with power supply cut-off means**
Leistungsgleichrichter mit Stromversorgungsabschaltungsmittel
Redresseur de puissance avec moyens de coupure de alimentation de puissance

(43) Date of publication of application: 01.10.2003
(73) Proprietor: POWER ONE ITALY S.p.A., Terranuova Bracciolini (AR) (IT)
(72) Inventor: Canova, Antonio, 52025 Montevarchi, Arezzo (IT); Cincinelli, Lorenzo, 52023 Levane, Arezzo (IT); Piazzesi, Mauro, 52028 Terranuova Bracciolini, Arezzo (IT)
(74) Representative: Mannucci, Michele

(56) References cited:
- EP-A- 1 146 620
- US-A- 4 532 443
- US-A- 5 864 476
- US-A- 6 014 322
- MATSUKAWA T ET AL: "Application of parallel connected power-MOSFET elements to high current d.c. power supply" FUSION ENGINEERING AND DESIGN, ELSEVIER SCIENCE PUBLISHERS, AMSTERDAM, NL, vol. 58-59, November 2001 (2001-11), pages 63-67, XP004312859 ISSN: 0920-3796

## Description

The present invention relates to a power rectifier of the type comprising an output for connection to a supply line leading to a load, in which line there is a cut-off device for breaking the connection between the rectifier and the supply line in case of a malfunction of the rectifier.

There are known devices of this type. These are used when a plurality of power rectifiers is connected in parallel to a single supply line leading to a load, which has a considerable current requirement. In this situation, if a fault occurs in one of these rectifiers, it is necessary to prevent the current flowing in the supply line from entering the faulty rectifier, as this would cause a severe disturbance in the common supply voltage (bus output).

At the present time, an arrangement of diodes is provided at the output of the rectifier (on either the positive or the negative terminal) to prevent such an occurrence, these diodes entering the cut-off state when the current at the output of the rectifier tends to be inverted as a result of a fault in the rectifier.

These known devices have the advantage of a rapid response speed, but have high dissipation when high currents are present. This not only reduces efficiency, but also makes it necessary to provide efficient heat sinks, in thermal contact with the diodes, to remove the heat generated by the Joule effect in the diodes during the normal operation of the rectifier.

EP-A-1146620 discloses a circuit of the above type wherein the rectifier includes a cut-off device which comprises, instead of a set of diodes, a plurality of MOSFETs in parallel and a control circuit which makes the MOSFETs non-conducting when the output current from the rectifier tends to become inverted. The control circuit requires a current detection device in the form of a resistor. The voltage drop across the resistor is a function of the output current. Said voltage is applied to the inverting input terminal of an operational amplifier of the control circuit.

The object of the present invention is to provide a power rectifier of the type described above which does not have the drawbacks of the conventional devices.

The present invention relates to a power rectifier according to claim 1.

According to the invention, the control circuit which controls the MOSFET's comprises an operational amplifier to whose inputs are applied voltages proportional to the source and drain voltages of the MOSFET. A reactive circuit with a capacitor is advantageously provided between the inverting terminal and the output of the operational amplifier, to prevent oscillation of the output of the operational amplifier in the proximity of the trigger threshold at which the MOSFET becomes non-conducting.

Further advantageous characteristics and embodiments of the device according to the invention are indicated in the attached dependent claims.

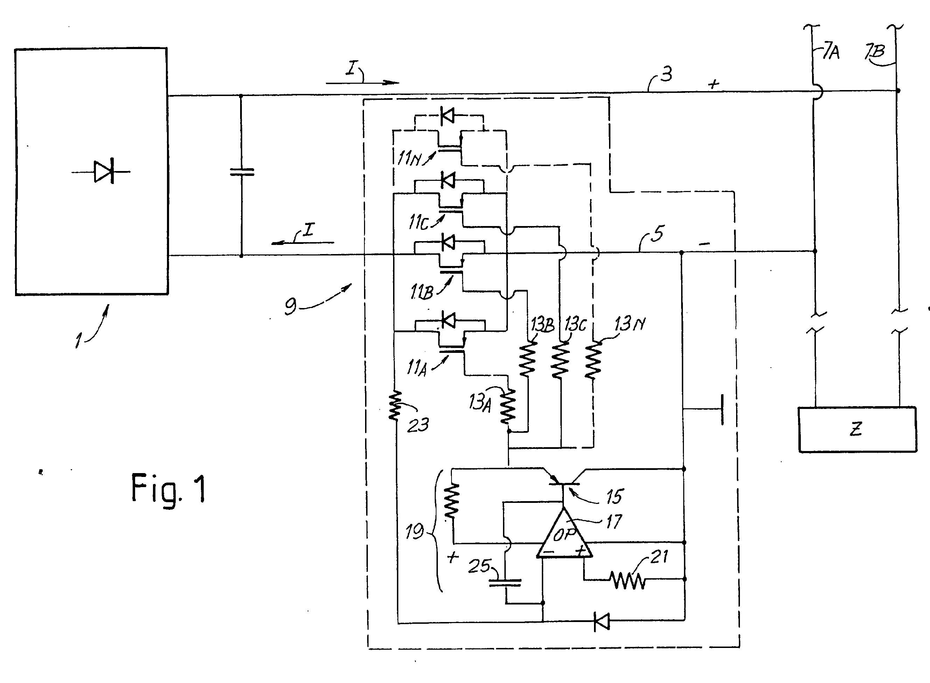

The invention will be more clearly understood from the description and the attached drawing, which shows in the single figure an electrical circuit diagram of the device according to the invention.

With reference to the drawing, the number 1 indicates in a general and schematic way a power rectifier, whose internal structure is known to those skilled in the art and will not be described in detail in this document. The rectifier typically operates over a power range from hundreds to thousands of watts, for example at levels above 100 watts, and in particular above 400 watts, and with an output voltage which is typically of the order of several tens to several hundreds of volts.

The positive and negative terminals, indicated by 3 and 5 respectively, of the rectifier 1 are connected to a power supply line 7A, 7B to which are connected in parallel other rectifiers which are similar to that illustrated in the figure and which are not shown. The supply line 7A, 7B is connected to a load indicated in a general and schematic way by Z.

The cut-off device associated with the power rectifier 1 can be connected to the positive output terminal 3 or to the negative output terminal 5 of the rectifier. In the example illustrated in the figure, it is connected to the negative terminal, and is indicated in a general way by 9. The cut-off device 9 comprises a plurality of MOSFETs, indicated by 11A, 11B, 11C ... 11N. The MOSFETs 11A-11N are connected in parallel with each other and are connected to the negative output terminal 5 of the rectifier in such a way that the current supplied by the latter is distributed among the various MOSFETs and flows between the source and drain of each of them.

The gates of all the MOSFETs are connected, via corresponding resistors 13A, 13B, 13C, 13N to the emitter of a transistor 15. The collector of the transistor 15 is connected to the negative output terminal of the rectifier 1 before the group of MOSFETs 11A-11 N, while the base of the transistor 15 is connected to the output of an operational amplifier 17 forming the main element of the control circuit, indicated as a whole by 19, associated with the MOSFETs 11A-11N.

The non-inverting input of the operational amplifier 17 is connected, via a resistor 21, to the negative output terminal of the rectifier 1, before the MOSFETs 11A-11N according to the conventional direction of flow of the current supplied by the rectifier, while the inverting terminal of the operational amplifier 17 is connected, via a resistor 23, to the negative output terminal 5 of the rectifier 1 after the MOSFETs 11A-11N.

A reactive filter containing a capacitor 25 is provided between the inverting terminal and the output of the operational amplifier 17, to prevent oscillations of the output of the operational amplifier 17 in the proximity of the trigger threshold.

The operation of the circuit described above is as follows. In normal operating conditions, the rectifier 1 provides the supply line 7A, 7B with a current I, which is added to the current supplied to the other rectifiers connected to the supply line 7A, 7B, to supply the load Z. In these conditions, a limited voltage drop is established between the source and drain of each MOSFET 11A-11N, and is kept approximately constant until the value of the current tends toward zero, for example if the rectifier 1 suffers an internal fault, which could lead to an inversion of the current at the output of said rectifier, a situation which must be avoided.

When this type of fault situation arises, the voltage drop between the sources and drains of the various MOSFETs 11A-11N causes a reduction of the output voltage of the operational amplifier 17. The reduction of the output voltage of the operational amplifier causes the transistor 15 to conduct. Since the transistor 15 is connected via the resistors 13A-13N to the gates of the MOSFETs 11A-11N, its switching to the conducting state rapidly makes all the MOSFETs non-conducting. Thus the connection between the supply line 7A-7B and the power rectifier 1 is rapidly broken. The reactive filter formed by the capacitor 25 prevents any possible oscillations of the output of the operational amplifier 17 in the proximity of the intervention threshold.

## Claims

1. Power rectifier comprising an output (3, 5) for connection to a supply line (7A, 7B) leading to a load (Z), a cut-off device (9) being connected to said output to break the connection between said rectifier and said supply line, wherein said cut-off device comprises a plurality of MOSFETs (11A-11B) in parallel and a control circuit (19) to make said MOSFETs non-conducting when the output current of said rectifier tends to become inverted, **characterized in that** said control circuit comprises an operational amplifier (17) to whose inputs are applied voltages proportional to the source-drain voltages of said MOSFETs.

2. Rectifier according to claim 1, **characterized in that** said operational amplifier has a reactive filter comprising a capacitor (25).

3. Rectifier according to claim 1 or 2, **characterized in that** the output of said operational amplifier is connected to an electronic switch (15) connected to the gates of said MOSFETs, this switch remaining open in the normal operating conditions of said rectifier and becoming conducting if the cut-off device is triggered, thus making said MOSFETs non-conducting.

4. Power supply circuit comprising a supply line (7A, 7B) leading to a load (Z) and a plurality of power rectifiers connected to said supply line, **characterized in that** one or more of said rectifiers are constructed according to one or more of claims 1 to 3.

## Patentansprüche

1. Leistungsgleichrichter, der einen Ausgang (3, 5) zur Verbindung mit einer Zuleitung (7A, 7B), die zu einer Last (Z) führt, eine Abschaltvorrichtung (9), die mit dem Ausgang verbunden ist, um die Verbindung zwischen dem Gleichrichter und der Zuleitung zu unterbrechen, umfasst, wobei die Abschaltvorrichtung eine Anzahl von parallel geschalteten MOSFETs (11A-11B) und eine Steuerschaltung (19) umfasst, um die MOSFETs nicht leitend zu machen, wenn der Ausgangsstrom des Gleichrichters dazu neigt, invertiert zu werden, **dadurch gekennzeichnet, dass** die Steuerschaltung einen Operationsverstärker (17) umfasst, an dessen Eingänge Spannungen angelegt sind, die den Source-Drain-Spannungen der MOSFETs proportional sind.

2. Gleichrichter gemäß Anspruch 1, **dadurch gekennzeichnet, dass** der Operationsverstärker ein Reaktivfilter aufweist, das einen Kondensator (25) umfasst.

3. Gleichrichter gemäß Anspruch 1 oder 2, **dadurch gekennzeichnet, dass** der Ausgang des Operationsverstärkers mit einem elektronischen Schalter (15) verbunden ist, der mit den Gates der MOSFETs verbunden ist, wobei dieser Schalter unter normalen Betriebsbedingungen des Gleichrichters offen bleibt und leitend wird, wenn die Abschaltvorrichtung ausgelöst wird, so dass die MOSFETs nicht leitend gemacht werden.

4. Stromversorgungsschaltung, die eine Zuleitung (7A, 7B), die zu einer Last (Z) führt, und eine Anzahl von Leistungsgleichrichtern, die mit der Zuleitung verbunden sind, umfasst, **dadurch gekennzeichnet, dass** einer oder mehrere der Gleichrichter gemäß einem oder mehreren der Ansprüche 1 bis 3 aufgebaut sind.

## Revendications

1. Redresseur de puissance comprenant une sortie (3, 5) pour raccordement à une ligne d'alimentation (7A, 7B) conduisant à une charge (Z), un dispositif de coupure (9) étant raccordé à ladite sortie pour couper la connexion entre ledit redresseur et ladite ligne d'alimentation, dans lequel ledit dispositif de coupure comprend une pluralité de MOSFET (11A-11B) en parallèle et un circuit de commande (19) pour rendre lesdits MOSFET non conducteurs lorsque le courant de sortie dudit redresseur tend à devenir inversé, **caractérisé en ce que** ledit circuit de commande comprend un amplificateur opérationnel (17) dont les entrées reçoivent des tensions proportionnelles aux tensions source-drain desdits MOSFET.

2. Redresseur selon la revendication 1, **caractérisé en ce que** ledit amplificateur opérationnel a un filtre réactif comprenant un condensateur (25).

3. Redresseur selon la revendication 1 ou 2, **caractérisé en ce que** la sortie dudit amplificateur opérationnel est raccordée à un commutateur électronique (15) raccordé aux grilles desdits MOSFET, ce commutateur étant ouvert dans les conditions de fonctionnement normal dudit redresseur et devenant conducteur si le dispositif de coupure est déclenché, rendant ainsi lesdits MOSFET non conducteurs.

4. Circuit d'alimentation de puissance comprenant une ligne d'alimentation (7A, 7B) conduisant à une charge (Z) et une pluralité de redresseurs de puissance raccordés à ladite ligne d'alimentation, **caractérisé en ce qu'**un ou plusieurs desdits redresseurs sont construits selon une ou plusieurs des revendications 1 à 3.
